## Europäisches Patentamt
## European Patent Office
## Office européen des brevets

(19)

(11) Veröffentlichungsnummer: **0 514 398 B1**

(12)
# EUROPÄISCHE PATENTSCHRIFT

(45) Veröffentlichungstag der Patentschrift: **17.08.94**

(51) Int. Cl.5: **H03D 3/24**

(21) Anmeldenummer: **91902697.1**

(22) Anmeldetag: **29.01.91**

(86) Internationale Anmeldenummer:
**PCT/EP91/00162**

(87) Internationale Veröffentlichungsnummer:
**WO 91/11853 (08.08.91 91/18)**

---

(54) **INTEGRIERTER FM-DETEKTOR.**

---

(30) Priorität: **05.02.90 DE 4003418**

(43) Veröffentlichungstag der Anmeldung:
**25.11.92 Patentblatt 92/48**

(45) Bekanntmachung des Hinweises auf die
Patenterteilung:
**17.08.94 Patentblatt 94/33**

(84) Benannte Vertragsstaaten:
**DE FR GB IT NL**

(56) Entgegenhaltungen:
**EP-A- 0 395 860**
**US-A- 3 694 772**
**US-A- 3 869 679**

**IEEE Transactions on Consumer Electronics,
vol. 34, no. 3, August 1988,IEEE, (New York,
US). Y.Yamamoto et al.: "A new audio processor for EIAJ MTS", p. 625-633.**

(73) Patentinhaber: **Deutsche Thomson-Brandt
GmbH
Hermann-Schwer-Strasse 3
Postfach 1307
D-78003 Villingen-Schwenningen(DE)**

(72) Erfinder: **RIEGER, Martin
Alte Str. 14
D-7210 Rottweil-Neukirch(DE)**
Erfinder: **ROTH, Sabine
Auf der Wanne 67
D-7730 VS-Villingen(DE)**

(74) Vertreter: **Einsel, Robert, Dipl.-Ing.
Deutsche Thomson-Brandt GmbH
Patent- und Lizenzabteilung
Göttinger Chaussee 76
D-30453 Hannover (DE)**

---

**Beschreibung**

Die Erfindung betrifft einen FM-Detektor zur Demodulierung von Signalen, insbesondere von Ton-Signalen, gemäß dem Oberbegriff des Anspruchs 1. Ein solcher FM-Detektor ist bekannt aus IEEE Transactions on Consumer Electronics, Band 34, Nr. 3 August 1988, IEEE; New York, US;Y. Yamamoto et al.: "A New Audio Processor for EIAJ MTS", Seiten 625-633.

Solche FM-Detektoren werden vorzugsweise dort eingesetzt, wo frequenzmodulierte Signale in niederfrequente Ton-Signale umgesetzt werden müssen. Dies ist insbesondere in Fernseh- oder Rundfunkempfängern der Fall.

Wie bei vielen anderen Schaltungsteilen in einem Fernseh- oder Rundfunkempfänger geht die Bestrebung auch für die FM-Detektoren dahin, diese platzsparend anzuordnen. Bisherige FM-Detektoren werden zwar schon teilweise auf einem Baustein integriert, müssen jedoch mit externen Bauteilen, wie beispielsweise Keramikfiltern oder LC-Kreisen, ausgestattet werden, um ein gutes Signal-/Rauschverhältnis aufzuweisen oder um thermische Drift der Ladungsträger zu vermeiden. Außerdem ist häufig eine aufwendige Justierung und Abstimmung der FM-Detektoren und der externen Bauteile nötig.

Der Erfindung liegt die Aufgabe zugrunde, einen integrierten FM-Detektor der beschriebenen Art so auszubilden, daß eine einfache Steuerung des FM-Detektors gewährleistet und der Aufwand an externen Bauteilen für die Einstellung der internen Betriebsbedingungen sowie der Aufwand für die manuellen Einstellung der externen Bauteile verringert wird.

Der Erfindung liegt die Aufgabe zugrunde, einen integrierten FM-Detektor der beschriebenen Art so auszubilden, daß der Aufwand an externen Bauteilen für die Einstellung der internen Betriebsbedingungen sowie der Aufwand für die manuelle Einstellung der externen Bauteile verringert wird.

Diese Aufgabe löst die Erfindung dadurch, daß die externen Bauteile durch interne auf dem Baustein angeordnete Regel- oder Steuerschaltung realisiert sind. Vorteilhafte Weiterbildungen der Erfindung sind in den Unteransprüchen und der weiteren Beschreibung beschrieben.

Nachstehend wird ein Ausführungsbeispiel der Erfindung anhand der Zeichnungen näher erläutert. Diese zeigen in:

Fig.1    ein Schaltungsprinzipbild eines erfindungsgemäßen FM-Detektors,

Fig. 2    ein schematisches Oszillatorschaltbild mit zugehörigen Zeitdiagrammen,

Fig. 3    ein Schaltbild eines vollintegrierten FM-Detektors,

Fig. 4    ein exaktes Schaltbild eines FM-Detektors gemäß Fig. 3,

Fig. 5    ein Abgleichbaum mit FM-Detektoren gemäß der vor herigen Figuren.

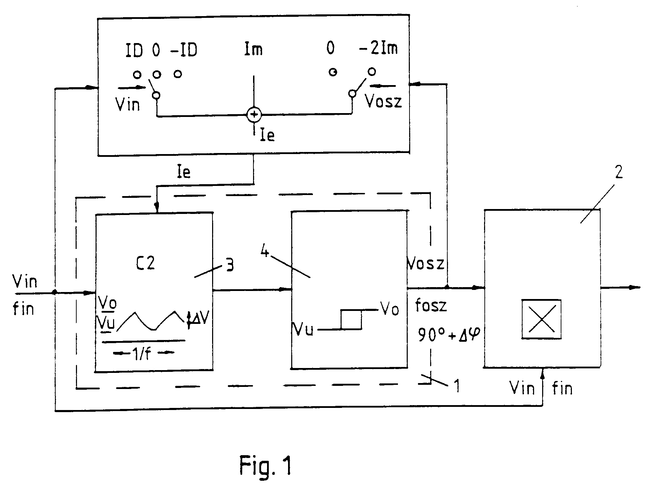

Fig. 1 zeigt einen prinzipiellen Schaltungsaufbau eines FM-Detektors (= FM-Demodulator). Die Schaltung besteht im wesentlichen aus einem Phasenregelkreis mit einem stromgesteuerten Oszillator 1 und einem Vierquadranten/Analogmultiplizierer 2 als Phasendetektor. Der Oszillator 1 besteht aus einem stromgesteuerten Ladekondensator 3 und einem Schmitt-Trigger 4. Die Freilauffrequenz des Oszilators trägt $f0 = (2\Delta VC_2/I_m)^{-1}$. $\Delta V$ ist die Spannungsdifferenz zwischen der Spannung Vu und Vo des Ladekondensators, $C2$ die Kapazität des Ladekondensators 3. Vu und Vo sind die Schaltpotentiale des Schmitt-Triggers. Vu ist das Low-Potential, Vo das High-Potential. Die Funktionsweise des Schmitt-Triggers ist bekannt (siehe Tietze/Schenk "Halbleiter-Schaltungstechnik, Seite 182 und 222ff). Im stationären Zustand wird der Ladekondensator durch den mittleren Gleichstrom $I_m$ aufgeladen. Je nach Zustand des Schmitt-Triggers und damit der Oszillatorspannung $V_{osz}$ wird der Schalter 5 wechselweise auf 0 oder $-2I_m$ eingestellt und der jeweilige Strom ($-2I_m$ oder 0) mit $I_m$ überlagert. Der sich daraus ergebende resultierende Strom le ($=I_m$ oder $-I_m$) lädt also den Ladekondensator auf oder entlädt ihn. Der Schalter 6 steht nach Einrastung der Oszillatorfrequenz (also im stationären Zustand) auf die Eingangsfrequenz auf 0. Anderenfalls wird Schalter 6 auf Id oder -Id umgeschaltet, um die Oszillatorfrequenz auf die Eingangsfrequenz einzurasten. Dabei dient der Strom Id oder -Id als Gleichstromkompensationsstrom und überlagert sich ebenfalls mit Im oder Im. Somit kann der Ladekondensator und damit der Oszillator im Bereich $f0 - \Delta f$ bis $f0 + \Delta f$ auf die Eingangsfrequenz $f_{in}$des Eingangssignals einrasten. Als Ausgangsgleichung dient hier bei: $\Delta f/f0 = I_d/I_m$. Für eine unmodulierte Eingangsfrequenz $f_{in} = f0$ stellt sich am Ausgang des Schmitt-Triggers, also am Ausgang des Oszillators, eine Phasenverschiebung von 90° ein. Bei einem frequenzmodulierten Eingangssignal ergibt sich eine zusätzliche Phasenverschiebung von $\Delta\gamma$ proportional $f_{in}$-f0. Der Phasendetektor 2 mischt nun das Oszillatorsignal vom Ausgang des Schmitt-Triggers mit der Oszillatorspannung $V_{osz}$ (mit der Oszilatorfrequenz $f_{osz}$) mit dem Eingangssignal mit der Eingangsspannung $V_{in}$ (und der Eingangsfrequenz $f_{in}$) und stellt am Ausgang des Phasendetektors ein pulsweitenmoduliertes Signal zur Verfügung. Dieses pulsweitenmodulierte Signal kann beispielsweise durch einen nachgeschalteten Tiefpass (nicht dargestellt) in ein niederfrequentes Tonsignal umgewandelt werden.

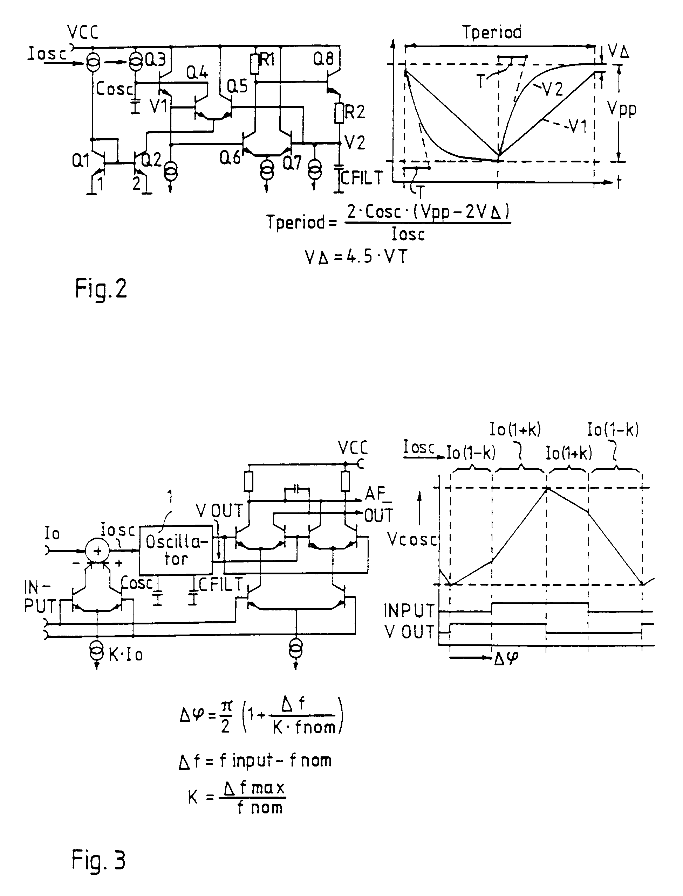

Fig. 2 zeigt ein schematisches Oszillatorschaltbild mit dem dazugehörigen Zeitdiagramm. Die

Transistoren $Q_6$-$Q_8$ bilden einen Schmitt-Trigger, der einen Differenzverstärker steuert, der als Schalter ausgelegt ist. Dadurch wird eine Dreiecksspannung erzeugt, wie im Zeitdiagramm in Fig. 2 gezeigt.

Besondere Beachtung bei diesem Oszillator findet das Rauschverhalten. Um ein gutes Rauschverhalten zu bekommen, ist es notwendig, die Bandbreite des Schmitt-Triggers zu begrenzen. Dafür ist eine Filterkapazität $C_{Filt}$ vorgesehen. Die Zeitkonstante ist so groß wie möglich, aber klein genug, um eine zu große Frequenzabweichung zu vermeiden (T = 0, 13 x $T_{Periode}$). Ohne diese Filterung ist das Rauschverhalten des FM-Detektors nicht ausreichend.

Wie schon in Fig. 1 gezeigt, ist der Oszillator 1 der Kern des FM-Detektors. Der Steuerstrom $I_0$ (in Fig. 3) wird von dem Eingangssignal moduliert. Wenn seine Frequenz nahe der Freilauffrequenz des Oszillators $f_Z$ ist, wird er synchronisiert und zeigt das Zeitverhalten wie im Timing-Diagramm in Fig. 3 gezeigt. Wenn das ankommende Eingangssignal die gleich Frequenz wie die Freilauffrequenz des Oszillators hat, ist eine Phasendrehung von 90° gegeben. Bei Abweichung von der Freilauffrequenz ergibt sich eine lineare Phasenabweichung (siehe Fig. 3). Simulation und Messung eines produzierten Bausteines zeigten ein gutes Verhalten (Signal-/Rauschsbstand 70 dB, Verzerrung kleiner als 2%, Seitenträgerabstand 40 dB) auf.

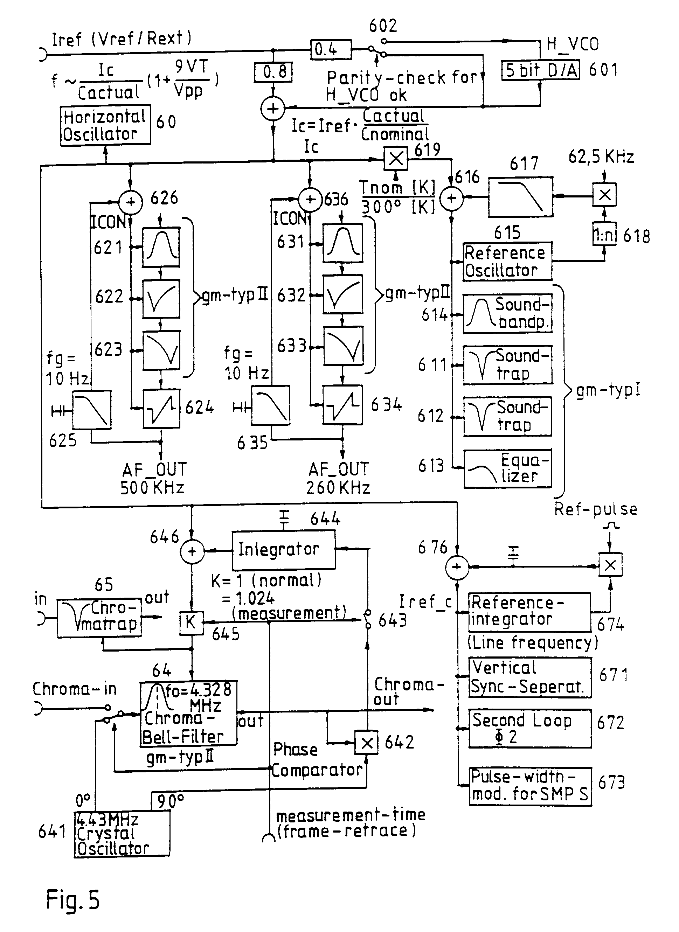

Zur Herstellung von "One Chip"-Empfängern müssen in integrierten Schaltkreisen enthaltene analoge Schaltungen, z.B. Filter, aber auch FM-Detektoren bedingt durch Bauelementetoleranzen und Fertigungsstreuungen, abgeglichen werden. Dazu ist ein Abgleichbaum wie in Fig. 5 gezeigt, vorgesehen. Dieser zeigt einen Horizontal-Frequenz-Oszillator 60. Er ist das Referenzschaltungsteil.

Seine Frequenz kann leicht gemessen und mit Hilfe des 5-Bit-D/A-Wandlers 601 mit einem Fehler von kleiner +- 1 % abgeglichen werden. Der D/A-Wandler 601 ist bei der Fernsehgeräte-Produktion softwaremäßig abgleichbar, der Abgleich ist dann gespeichert.

Durch hohe Spannungsstöße in der Umgebung dieses D/A-Wandlers kann der Speicherinhalt in unerwünschter Weise geändert werden. Wenn dadurch die Horizontalfrequenz zu niedrig würde, könnte die Horizontalendstufe und ein Switch-Mode-Netzteil zerstört werden. Darum wird im D/A-Wandler 601 eine Parity-Prüfung durchgeführt. Wenn diese Prüfung einen Fehler ergibt, wird durch Schalter 602 ein maximaler Steuerstrom eingestellt. Dadurch erhöht sich die Horizontalfrequenz und eine Zerstörung von Schaltungen wird verhindert.

Wenn der Horizontalfrequenzoszillator 60 abgeglichen ist, ergibt sich der Steuerstrom Ic aus dem Referenzstrom Iref = Vref / Rext . Bedingt durch Herstellungstoleranzen haben z.B. die Kondensatoren in der integrierten Schaltung einen tatsächlichen Wert Cactual im Vergleich zu einem Sollwert Cnominal. Dadurch ist der Steuerstrom Ic kapazitäts-abgeglichen ('capacitor-adjusted') und hat z.B. den Wert Ic = Iref * Cactual / Cnominal . Cactual wird praktisch indirekt über die Frequenzmessung des Horizontalfrequenzoszillators 60 gemessen.

Die Ausgangsfrequenz des Horizontalfrequenz-Oszillators ist zwar im Wesentlichen abhängig vom Steuerstrom Ic, hat aber z.B. auch noch eine geringe Abhängigkeit von der Temperaturspannung Vt und der Spitze-Spitze-Ausgangsspannung Vpp . Dadurch ergibt sich diese Frequenz zu ca. Ic / Cactual * (1 + 9 * Vt / Vpp) und folglich die Notwendigkeit, bestimmte, vom Steuerstrom Ic abgeglichene, analoge Schaltungsteile noch einem Feinabgleich zu unterziehen.

Aus diesem Grunde sind in der integrierten Schaltung fünf Regelschleifen für verschiedene Schaltungsteile vorhanden, in denen der Steuerstrom Ic mit einem Korrekturstrom (Icon) in den Summationspunkten 616, 626, 636, 646 und 676 verknüpft wird.

Die Analogfilter 621 - 623 und der FM-Demodulator 624 bereiten einen ersten Tonkanal auf, die Analogfilter 631 - 633 und der FM-Demodulator 634 bereiten einen zweiten Tonkanal auf. Das Kriterium für den Feinabgleich der beiden Tonkanäle ist der Gleichspannungs-Offset an den Ausgängen der FM-Demodulatoren 624 bzw. 634. Die Ausgangsspannungen werden in den Tiefpässen 625 bzw. 635 mit einer Grenzfrequenz von 10 Hz gefiltert. Die sich ergebenden Gleichspannungsanteile erzeugen jeweils den Korrekturstrom Icon.

Der Feinabgleich der Ton-Fallen 611 - 612 und des Equalizers 613 in der Bild-ZF und des Vorselektionsfilters 614 in der Ton-ZF wird mit Hilfe eines zusätzlichen Referenz-Biquad-Filters 617 durchgeführt, welches in der Rückkopplung einer PLL-Schleife angeordnet ist. Die PLL-Schleife beinhaltet einen Referenzoszillator 615 und einen programmierbaren 1:n-Teiler 618. Dabei liegt die Grenzfrequenz des Referenz-Biquad-Filters 617 passend zur Frequenzlage der Ton-Fallen 611 - 612, des Equalizers 613 und des Vorselektionsfilters 614, sodaß sich ein guter Gleichlauf ergibt.

Weil für die Ton-Fallen 611 - 612, den Equalizer 613 und das Vorselektionsfilter 614 wegen der hohen zu verarbeitenden Frequenzen gm-Verstärker Typ 1 verwendet werden, wird der Steuerstrom Ic noch in der Schaltung 619 einer temperaturabhängigen Korrektur unterworfen.

Beim Feinabgleich des Chroma-Glockenfilters 64 darf nur ein Fehler von maximal +- 0.4 % auftreten. Außerdem muß die Güte des Chroma-GlockenfilterS 64 den Wert sechzehn erreichen. Darum wird ein unterschiedliches Feinabgleich-Verfahren angewandt. Während des vertikalen Zeilenrücklaufs (frame) wird dieses Filter in einen Abgleich-Mode umgeschaltet. Ein Quartzoszillator 641 mit der PAL-Farbträgerfrequenz 4.43 MHz wird an das Filter angelegt und in einem Phasenkomparator 642 die Phase am Ein- und Ausgang des Filters verglichen. Wenn die Phasendifferenz null ist, stimmt die Mittenfrequenz des Chroma-Glockenfilters 64 mit der PAL-Farbträgerfrequenz überein. Der Phasenkomparator 642 ist mit einer Abtast- und Halteschaltung 643 verbunden. Weil geringe Leckströme erforderlich sind, hat die Abtast- und Halteschaltung 643 Operationsverstärker mit NMOS-Eingängen (nicht dargestellt). Es schließt sich ein Integrator 644 an, der den Korrekturstrom für den Steuerstrom Ic erzeugt. Zusätzlich wird während der Meßzeit durch die Korrekturschaltung 645 ein kleiner Korrekturfaktor von ca. 2.3 % eingeführt, weil die Soll-Mittenfrequenz (4.328 MHz) des Chroma-Glockenfilters 64 etwas von der PAL-Farbträgerfrequenz (4.43 MHz) abweicht.

Der Abgleich der Farbträgerfalle 65 ist weniger kritisch. Es wird der gleiche Steuerstrom wie für das Chroma-Glockenfilter 64 verwendet.

Der Steuerstrom-Korrekturwert für einen vertikalen Sync-Separator 671, eine Phi2-Schleifenschaltung 672 und einen Pulsweitenmodulator 673 für ein Switch-Mode-Netzteil wird über eine weitere PLL-Schleife mit einem Referenzintegrator 674 gewonnen.

Das beschriebene Abgleichverfahren mit dem selbsttätigen Feinabgleich ist für integrierte Schaltungen in Bipolar- und BICMOS-Technologie geeignet.

Durch den zusätzlichen Feinabgleich wird vorteilhaft auch eine Temperaturabhängigkeit der Schaltungsteile eliminiert.

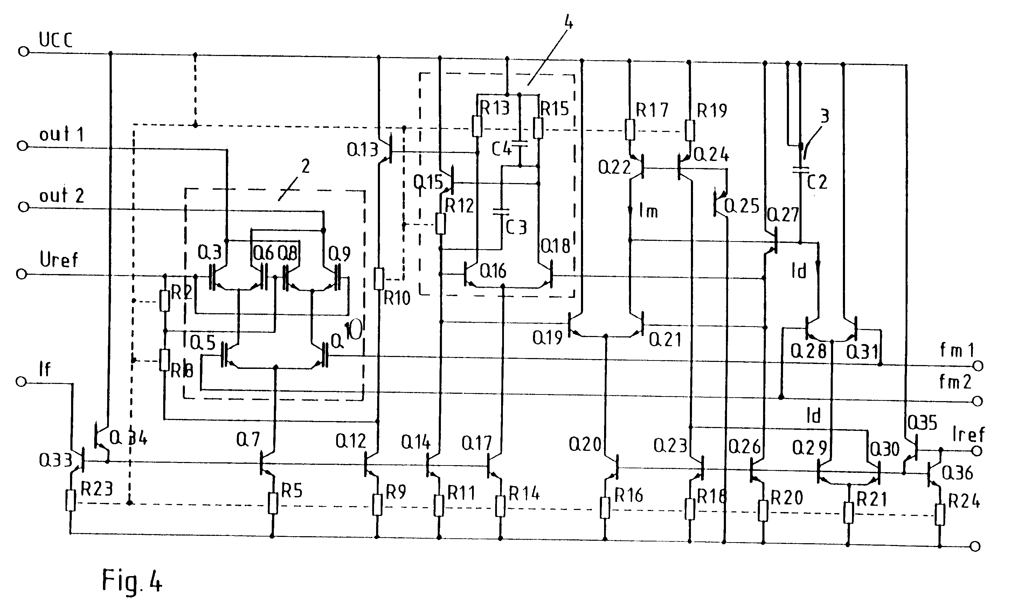

In Fig. 4 ist ein exaktes Schaltbild eines FM-Detektors, dessen Mittenfrequenz auf 500 kHz abgestimmt ist, dargestellt. Der Phasendetektor 2 wird aus den Transistoren $Q_3$, $Q_5$, $Q_6$, $Q_8$, $Q_9$ und $Q_{10}$ gebildet. Der Schmitt-Trigger aus den Transistoren $Q_{15}$, $Q_{16}$ und $Q_{18}$ sowie den Widerständen $R_{12}$, $R_{13}$, $R_{15}$ sowie den Kapazitäten $C_4$ und $C_3$. Dem Strom $I_m$ liefert der Transistor $Q_{22}$, den Strom $-2I_m$ liefert der Transistor $Q_{30}$ oder alternativ $Q_{21}$. Den Strom $I_d$ liefert der Transistor $Q_{28}$.

**Patentansprüche**

1. FM-Detektor zur Demodulierung von Signalen, insbesondere von Tonsignalen, wobei der FM-Detektor auf einem Baustein integriert ist und dessen Funktion durch interne auf dem Baustein angeordnete Regel- oder Steuerschaltungen einstellbar sind, wobei der FM-Detektor in einem Fernseh- oder Rundfunkempfänger ausgebildet ist, wobei der FM-Detektor aus einem Phasendetektor (2) besteht, der ein Eingangssignal mit einem Oszillatorsignal mischt, und wobei das Oszillatorsignal von einem Oszillator (1) erzeugt ist, der durch das Eingangssignal des FM-Detektors, durch das Ausgangssignal des Oszillators selbst und durch eine fest einstellbare Bezugsgröße steuerbar ist, und wobei der Oszillator (1) aus einem Ladekondensator (3) und einem Schmitt-Trigger (4) besteht, **dadurch gekennzeichnet**, daß der Ladekondensator (3) durch das Eingangssignal und durch einen Ladestrom $I_e$ steuerbar ist, daß das Ausgangssignal ($V_{osz}$) des Oszillators (1) einen Schalter (5) steuert, der wahlweise dem Ladestrom $I_e$ einen Strom $-2I_m$ oder Null x $I_m$ beaufschlagt, wobie $I_m$ der mittlere Gleichstrom ist, mit dem der Ladekondensator im stationären Zustand aufgeladen wird, daß eine feinere Steuerung des Ladestroms in Abhängigkeit des Eingangssignals über einen weiteren Schalter (6) vorgesehen ist, wobei dieser Zusatzstrom gleich Null ist, wenn die Oszillatorfrequenz auf die Eingangsfrequenz einrastet, und der Gesamtladestrom die Summe dieser beiden Teilströme bildet.

2. FM-Detektor nach Anspruch 1, **dadurch gekennzeichnet**, daß der FM-Detektor für eine Mittenfrequenz von etwa 500 kHz oder von etwa 260 kHz ausgelegt ist.

3. FM-Detektor nach Anspruch 1, **dadurch gekennzeichnet**, daß sich bei Einrastung der Oszillatorfrequenz auf die Eingangsfrequenz am Ausgang des Schmitt-Triggers (4) eine Phasenverschiebung von 90° einstellt.

4. FM-Detektor nach Anspruch 3, **dadurch gekennzeichnet**, daß die Ausgangssignale des Phasendetektors impuls-weiten-moduliert sind.

5. FM-Detektor nach einem der vorhergehenden Ansprüche, **dadurch gekennzeichnet**, daß das Eingangssignal den weiteren Schalter (6) steuert, der den Ladestrom ($I_e$) des Kondensators abgleicht oder kompensiert und eine Einrastung der Oszillatorfrequenz auf die Eingangsfrequenz vornimmt.

6. FM-Detektor nach Anspruch 1, dadurch gekennzeichnet, daß der Schmitt-Trigger (4) ein unteres Schaltungspotential (Vu) und ein oberes Schaltungspotential (Vo) aufweist.

**7.** FM-Detektor nach Anspruch 6, dadurch gekennzeichnet, daß sich der Ladestrom (Ie) aus der Summation des Gleichstromes (Im) und der durch den Schalter (5) und den weiteren Schalter (6) einstellbaren Ströme ergibt.

**Claims**

**1.** FM detector for demodulating signals, in particular audio signals, the FM detector being integrated in a module and its operation being adjustable via internal regulating or control circuits disposed in the module, the FM detector being formed in a television or radio receiver and consisting of a phase detector (2), which mixes an input signal with an oscillator signal, the oscillator signal being produced by an oscillator (1), which can be controlled by the input signal of the FM detector, by the output signal of the oscillator itself and by a reference quantity, which can be adjusted so as to be constant, and the oscillator (1) consisting of a charging capacitor (3) and a Schmitt trigger (4), characterised in that the charging capacitor (3) can be controlled by the input signal and by a charging current $I_e$, that the output signal ($V_{osz}$) of the oscillator (1) controls a switch (5), which superimposes either a current $-2I_m$ or zero x $I_m$ on the charging current Ie, $I_m$ being the mean direct current with which the charging capacitor is charged in the steady state, that a finer control of the charging current is effected by means of an additional switch (6) in accordance with the input signal, this additional current being zero when the oscillator frequency locks onto the input frequency, and the total charging current constitutes the sum of these two component currents.

**2.** FM detector according to claim 1, characterised in that the FM detector is designed for a mid-band frequency of approximately 500 kHz or approximately 260 kHz.

**3.** FM detector according to claim 1, characterised in that a phase shift of 90° takes place at the output of the Schmitt trigger (4) when the oscillator frequency locks onto the input frequency.

**4.** EM detector according to claim 3, characterised in that the output signals of the phase detector are pulse-width modulated.

**5.** FM detector according to any one of the preceding claims, characterised in that the input signal controls the additional switch (6), which adjusts or compensates the charging current ($I_e$) of the capacitor and causes the oscillator frequency to lock onto the input frequency.

**6.** FM detector according to claim 1, characterised in that the Schmitt trigger (4) has a lower switching potential (Vu) and an upper switching potential (Vo).

**7.** FM detector according to claim 6, characterised in that the charging current (Ie) results from the summation of the direct current (Im) and the currents which can be adjusted by the switch (5) and the additional switch (6).

**Revendications**

**1.** Détecteur MF pour démoduler des signaux, en particulier des signaux audio, le détecteur MF étant intégré sur un composant et dont le fonctionnement est réglable par des circuits de réglage ou de commande internes placés sur le composant, le détecteur MF étant configuré dans un récepteur de télévision ou de radio, le détecteur MF étant constitué par un détecteur de phase (2) qui mélange un signal d'entrée à un signal d'oscillateur, le signal d'oscillateur étant généré par un oscillateur (1) qui peut être commandé par le signal d'entrée du détecteur MF, par le signal de sortie de l'oscillateur lui-même et par une grandeur de référence réglable de manière fixe, l'oscillateur (1) étant constitué par un condensateur de lissage (3) et un trigger de Schmitt (4), **caractérisé en ce** que le condensateur de lissage (3) peut être commandé par le signal d'entrée et par un courant de charge Ie, que le signal de sortie ($V_{osz}$) de l'oscillateur (1) commande un commutateur (5) qui charge au choix un courant $-2I_m$ ou zéro x $I_m$ au courant de charge Ie, $I_m$ étant le courant continu moyen avec lequel le condensateur de lissage est chargé à l'état stationnaire, qu'une commande plus précise du courant de charge en fonction du signal d'entrée est prévue par un autre commutateur (6), ce courant supplémentaire étant égal à zéro lorsque la fréquence de l'oscillateur se bloque sur la fréquence d'entrée et que le courant de charge total forme la somme de ces deux courants partiels.

**2.** Détecteur MF selon la revendication 1, **caractérisé en ce** que le détecteur MF est conçu pour une fréquence centrale d'environ 500 kHz ou d'environ 260 kHz.

**3.** Détecteur MF selon la revendication 1, **caractérisé en ce** que, lorsque la fréquence de l'oscillateur se bloque sur la fréquence d'entrée, un décalage de phase de 90° se règle à la sortie du trigger de Schmitt (4).

4. Détecteur MF selon la revendication 3, **caractérisé en ce** que les signaux de sortie du détecteur de phase sont modulés en largeur.

5. Détecteur MF selon l'une des revendications précédentes, **caractérisé en ce** que le signal d'entrée commande le commutateur supplémentaire (6) qui égalise ou compense le courant de charge ($I_e$) du condensateur et qui effectue un blocage de la fréquence de l'oscillateur sur la fréquence d'entrée.

6. Détecteur MF selon la revendication 1, **caractérisé en ce** que le trigger de Schmitt (4) présente un potentiel de commutation inférieur (Vu) et un potentiel de commutation supérieur (Vo).

7. Détecteur MF selon la revendication 6, **caractérisé en ce** que le courant de charge (Ie) résulte de l'addition du courant continu (Im) et des courants qui peuvent être ajustés par le commutateur (5) et le commutateur supplémentaire (6).

Fig. 1

$$Tperiod = \frac{2 \cdot Cosc \cdot (Vpp - 2V\Delta)}{Iosc}$$

$$V\Delta = 4.5 \cdot VT$$

Fig.2

$$\Delta\varphi = \frac{\pi}{2} \left( 1 + \frac{\Delta f}{K \cdot fnom} \right)$$

$$\Delta f = f\,input - f\,nom$$

$$K = \frac{\Delta f\,max}{f\,nom}$$

Fig. 3

Fig. 4

EP 0 514 398 B1

Iref (Vref / Rext)

602

$f \sim \dfrac{Ic}{Cactual}\left(1+\dfrac{9\,VT}{Vpp}\right)$

0.4

H_VCO

0.8

5 bit D/A 601

Parity-check for
H_VCO ok

Horizontal Oscillator 60

$Ic = Iref \cdot \dfrac{Cactual}{Cnominal}$

Ic

$\dfrac{Tnom\ [K]}{300°\ [K]}$ 619

616

617

62,5 KHz

626

ICON

636

ICON

615
Reference Oscillator

1:n 618

621

631

gm-typ II

gm-typ II

622

632

614 Sound-bandp.

623

633

611 Sound-trap

gm-typ I

fg = 10 Hz

fg = 10 Hz

624

634

612 Sound-trap

HH

625

HH

635

613 Equalizer

AF_OUT
500 KHz

AF_OUT
260 KHz

Ref-pulse

644

646

Integrator

676

65

in  Chro-matrap  out

K = 1 (normal)
= 1.024
(measurement)

643

Iref_c

Reference-integrator
(Line frequency) 674

K 645

64

Chroma-in

fo=4.328 MHz
Chroma-Bell-Filter
gm-typ II

out

Chroma-out

Vertical Sync-Seperat. 671

Second Loop Φ2 672

Phase Comparator

642

0°        90°

641 4.43MHz Crystal Oscillator

measurement-time
(frame-retrace)

Pulse-width-mod. for SMPS 673

Fig. 5